# EUROPÄISCHE PATENTSCHRIFT

(11) **EP 1 297 578 B1**
(45) Veröffentlichungstag und Bekanntmachung des Hinweises auf die Patenterteilung: **04.11.2009**
(21) Anmeldenummer: 01943122.0
(22) Anmeldetag: 18.05.2001
(51) Int. Cl.: H01L 33/00

(54) **LUMINESZENZDIODE**
LUMINESCENT DIODE
DIODE ELECTROLUMINESCENTE

(30) Priorität: 05.07.2000 DE 10032531
(43) Veröffentlichungstag der Anmeldung: 02.04.2003
(73) Patentinhaber: OSRAM Opto Semiconductors GmbH, 93055 Regensburg (DE)
(72) Erfinder: GRÖNNINGER, Günther, 92358 Seubersdorf (DE); HEIDBORN, Peter, 93197 Zeitlarn (DE)
(74) Vertreter: Epping - Hermann - Fischer
(86) Internationale Anmeldenummer: PCT/DE2001/001926
(87) Internationale Veröffentlichungsnummer: WO 2002/003476

(56) Entgegenhaltungen:
- DE-C- 19 630 689
- US-A- 5 153 889
- US-A- 5 534 717
- US-A- 5 665 984

## Beschreibung

Die Erfindung betrifft eine Lumineszenzdiode mit einem Halbleiterchip auf der Basis von GaAlAs mit einer mit Hilfe von Silizium amphoterisch dotierten Diodenschichtfolge, die eine p-dotierte Anodenschicht und eine n-dotierte Kathodenschicht aufweist, und mit einer an die n-dotierte Kathodenschicht anschließenden Fensterschicht auf der Basis von GaAlAs.

Eine derartige Lumineszenzdiode ist aus der DE 196 30 689 C1 bekannt. Bei der bekannten Lumineszenzdiode handelt es sich um eine Leuchtdiode, die infrarotes Licht emittiert. Die Leuchtdiode weist eine erste, durch Silizium amphoterisch dotierte GaAlAs-Schicht auf, die aus einer p-leitenden Teilschicht und einer darüber angeordneten n-leitenden Teilschicht besteht. Der Aluminiumgehalt in der GaAlAs-Schicht nimmt über die gesamte GaAlAs-Schicht stetig, exponentiell zu. An der Oberfläche der p-leitenden Teilschicht beträgt die Konzentration 0 Atom-%. An der Zone des pn-Übergangs ist die Aluminiumkonzentration auf 5 bis 10 Atom-% angestiegen und liegt an der Oberfläche der n-leitenden Teilschicht zwischen 25 und 40 Atom-%. Weiterhin verfügt die Leuchtdiode über eine zweite, auf der Oberflächenseite der n-leitenden Teilschicht der ersten GaAlAs-Schicht angeordnete, mit Tellur dotierte, n-leitende GaAlAs-Schicht. Auch in der zweiten GaAlAs-Schicht nimmt der Al-Gehalt stetig - exponentiell zu. Entlang der Grenzfläche zur ersten GaAlAs-Schicht liegt der Al-Gehalt zwischen 6 und 16 Atom-%. An der gegenüberliegenden Oberfläche beträgt der Al-Gehalt mindestens 24 Atom-%.

Insbesondere bei schwachen Strömen sinkt die Lichtleistung innerhalb von 1000 Betriebsstunden auf Werte unterhalb von 30 % der ursprünglichen Lichtleistung.

Ausgehend von diesem Stand der Technik liegt der Erfindung die Aufgabe zugrunde, eine Leuchtdiode mit verbessertem Degradationsverhalten zu schaffen.

Diese Aufgabe wird dadurch gelöst, daß die Dicke der Fensterschicht zwischen 3 µm und 30 µm liegt und daß die Fensterschicht mit Hilfe von Si oder Sn mit einer Nettokonzentration von weniger als 1 x 10¹⁸ cm⁻³ n-dotiert ist.

Es hat sich herausgestellt, daß die Degradation der Bauelemente wesentlich schwächer ausfällt, wenn die Dicke der Fensterschicht auf Werte zwischen 3 µm und 30 µm reduziert wird und wenn auf Tellur als Dotierstoff verzichtet wird. Außerdem trägt zum verbesserten Degradationsverhalten die geringe Nettokonzentration der Dotierung bei. Unter Nettokonzentration wird dabei die Differenz der Konzentration von Donatoren und Akzeptoren verstanden.

Weitere zweckmäßige Ausgestaltungen der Erfindung sind Gegenstand der abhängigen Ansprüche.

Nachfolgend wird die Erfindung im einzelnen anhand der beigefügten Zeichnung erläutert. Es zeigen:
- Figur 1: einen Querschnitt durch eine Leuchtdiode gemäß der Erfindung;
- Figur 2: ein Diagramm, in dem die räumliche Verteilung der Al-Konzentration in der Leuchtdiode aus Figur 1 dargestellt ist;
- Figur 3: ein Diagramm, in dem die relative Degradation der Strahlungsstärke bei Dauerbetrieb einer herkömmli- chen Leuchtdiode dargestellt ist;
- Figur 4: ein Diagramm, das die relative Degradation der Strahlungsstärke bei Dauerbetrieb einer Leuchtdiode gemäß der Erfindung zeigt;
- Figur 5: ein Diagramm mit einer Darstellung der relativen Degradation der Strahlungsstärke bei Pulsbetrieb einer herkömmlichen Leuchtdiode; und
- Figur 6: ein Diagramm mit einer Darstellung der relativen Degradation der Strahlungsstärke bei Pulsbetrieb der Leuchtdiode gemäß der Erfindung.

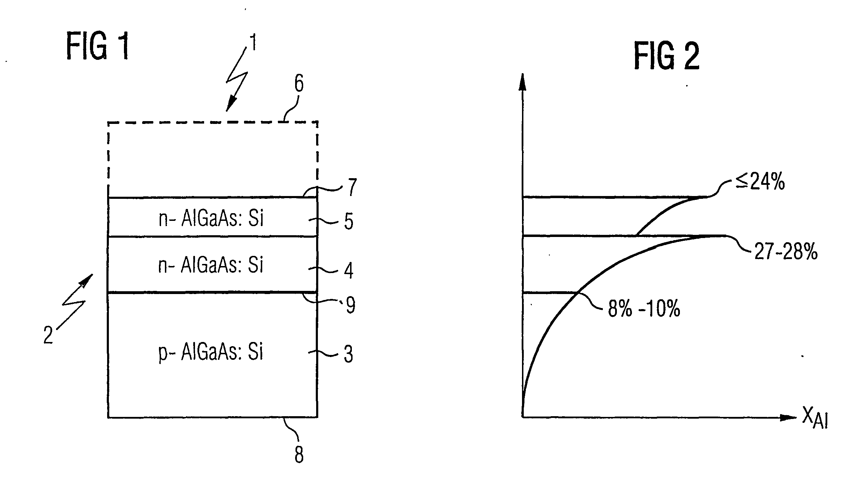

In Figur 1 ist ein Leuchtdiodenchip 1 dargestellt, der sich insbesondere zum Emittieren von infrarotem Licht eignet. Der Leuchtdiodenchip 1 verfügt über eine amphoterisch dotierte Diodenschicht 2, die sich aus einer mit Hilfe von Silizium p-dotiertem Anodenschicht 3 und einer mit Hilfe von Silizium n-dotierten Kathodenschicht zusammensetzt. Die Anodenschicht 3 und die Kathodenschicht 4 sind jeweils auf der Basis von AlGaAs hergestellt. An die Kathodenschicht 4 schließt sich eine ebenfalls mit Silizium n-dotierte Fensterschicht 5 auf der Basis von AlGaAs an. Während der Herstellung des Leuchtdiodenchips 1 befindet sich oberhalb der Fensterschicht 5 ein Substrat 6, das nach dem epitaktischen Aufwachsen der Fensterschicht 4 und der Diodenschicht 2 entfernt wird. Das Substrat 6 ist daher in Figur 1 gestrichelt eingezeichnet.

Auf einer Oberseite 7 und einer Unterseite 8 sind bei der fertigen Leuchtdiode 1 in Figur 1 nicht dargestellte Elektroden angebracht. Die Elektroden dienen dazu, Strom über einen pn-Übergang 9 zu lenken.

In Figur 2 ist die örtliche Verteilung der Al-Konzentration im Leuchtdiodenchip 1 dargestellt. Entlang der Unterseite 8 beträgt die Al-Konzentration X_{Al} in etwa 0 Atom-%. Über die Anodenschicht 3 hinweg steigt die Al-Konzentration stetig exponentiell an und erreicht am pn-Übergang 9 Werte zwischen 5 und 10 Atom-%. Vom pn-Übergang 9 ausgehend nimmt die Al-Konzentration weiter auf Werte zwischen 27 und 28 Atom-% zu. In der Fensterschicht 5 beginnt die Al-Konzentration mit Werten zwischen 6 bis 16 Atom-%. Im weiteren Verlauf steigt die Al-Konzentration ebenfalls stetig exponentiell auf Werte bis zu 24 Atom-% an der Oberseite 7 des Leuchtdiodenchips 1 an. Da die Größe der Bandlücke in AlGaAs mit wachsendem Al-Gehalt zunimmt, muß der minimale Gehalt von Al in der Fensterschicht 5 oberhalb des Al-Gehalts des pn-Übergangs 9 liegen, um zu verhindern, daß die im pn-Übergang 9 erzeugten Photonen in der Fensterschicht 5 absorbiert werden.

Durch den geringen Aluminiumgehalt auf der Oberseite 7 der Fensterschicht 5 läßt sich ein guter elektrischer Kontakt zwischen der auf der Fensterschicht 5 aufgebrachten Elektrode und der Fensterschicht 5 bewerkstelligen. Dadurch ist die Flußspannung auf niedrige Werte einstellbar, was die Verlustleistung im Leuchtdiodenchip 1 reduziert.

Weiterhin läßt sich die Degradation der Strahlungsstärke der vom Leuchtdiodenchip 1 ausgesandten Strahlung durch eine Reihe von Maßnahmen verringern.

Zum einen wird erfindungsgemäß die Dicke der Fensterschicht 5 auf Werte zwischen 3 µm und 30 µm, vorzugsweise zwischen 15 und 25 µm verringert. Durch die geringe Dikke der Fensterschicht 5 werden die Verspannung des Halbleiterchips reduziert und dadurch die Alterungsprozesse verringert.

Ferner wirkt es der Degradation entgegen, dass für die Dotierung des Halbleiterchips 1 ausschließlich Silizium oder Zinn verwendet wird. Die Verwendung von Tellur als Dotierstoff beschleunigt dagegen die Degradation.

Schließlich muss die Nettokonzentration der Dotierung unterhalb von 1 x 10¹⁸ cm⁻³ liegen. Unter Nettokonzentration ist dabei die Differenz der Konzentration von Akzeptoren und Donatoren zu verstehen.

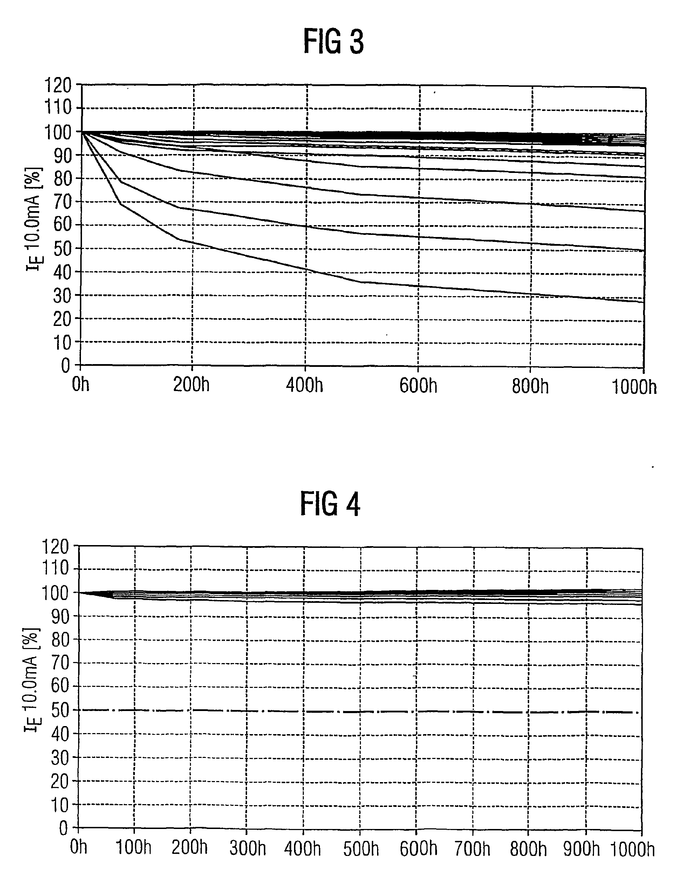

In den Figuren 3 bis 6 sind die Ergebnisse von verschiedenen Versuchen aufgetragen.

Fig. 3 und 4 zeigen die Niedrigstrom-Alterung bei 7 mA und 25 Grad Celsius.

Figur 3 enthält ein Diagramm, in dem die relative Änderung der Strahlungsstärke bei Dauerbetrieb von herkömmlichen Leuchtdiodenchips dargestellt ist. Im Rahmen dieser Versuche wurden herkömmliche Halbleiterchips über eine Zeit von 1000 Stunden ununterbrochen betrieben und die Strahlungsstärke mit Hilfe einer Photodiode gemessen. Anhand von Figur 3 wird deutlich, daß bei einigen Halbleiterchips eine relative Degradation bis auf 30 % des Anfangswerts stattfindet.

Im Gegensatz dazu zeigen die Messungen an den Leuchtdiodenchips 1 gemäß der Erfindung, daß auch bei einem Dauerbetrieb über 1000 Stunden keine Degradation der Strahlungsstärke stattfindet. Die Reduzierung der Fensterschichtdicke sowie die Dotierung ausschließlich mit Silizium und Zinn auf niedrigem Niveau wirkt sich somit vorteilhaft auf die Degradation des Leuchtdiodenchips 1 aus.

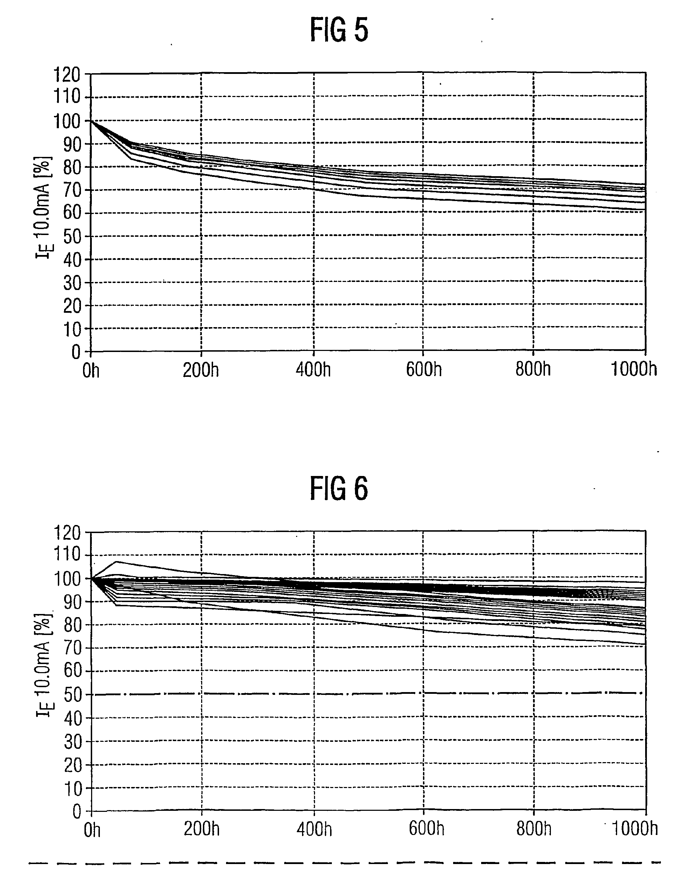

Das ein ähnliches Verhalten zeigen die Figuren 5 und 6, in denen das Hochstrom-Alterung dargestellt ist.

In Figur 5 sind Messungen herkömmlichen, gepulst betriebenen Halbleiterchips dargestellt. Die Dauer der Pulse betrug 100 µs. Die Zwischenzeit zwischen den Pulsen wurde mit 3 ms gewählt. Die herkömmlichen Leuchtdioden wurden mit einem Strom von 1500 mA belastet. Anhand von Figur 5 wird deutlich, daß alle geprüften herkömmlichen Leuchtdiodenchips nach 1000 Stunden weniger als 80 % der ursprünglichen Strahlungsstärke aufweisen.

Das Verhalten der Leuchtdiodenchips 1 gemäß der Erfindung ist zwar inhomogen, aber dafür existieren auch Leuchtdiodenchips 1, die keine oder nur eine sehr geringfügige Degradation aufweisen. Gemittelt über die einzelnen Proben fällt daher die Degradation der Leuchtdiodenchips 1 gemäß der Erfindung wesentlich schwächer aus als bei herkömmlichen Leuchtdiodenchips aus.

Es sei angemerkt, daß sich die beschriebene Leuchtdiode insbesondere zur Emission von Licht im infraroten Spektralbereich eignet.

## Patentansprüche

1. Lumineszenzdiode mit einem Halbleiterchip (1) auf der Basis von GaAlAs mit einer mit Hilfe von Silizium amphoterisch dotierten Diodenschichtfolge (2), die eine p-dotierte Anodenschicht (3) und eine n-dotierte Kathodenschicht (4) aufweist, und mit einer an die n-dotierte Kathodenschicht (4) anschließenden Fensterschicht (5) auf der Basis von GaAlAs,
**dadurch gekennzeichnet, daß**
die Dicke der Fensterschicht (5) zwischen 3 µm und 30 µm liegt und
daß die Fensterschicht (5) mit Hilfe von Si oder Sn mit einer Nettokonzentration von weniger als 1 x 10¹⁸ cm⁻³ n-dotiert ist.

2. Lumineszenzdiode nach Anspruch 1,
**dadurch gekennzeichnet, daß**
die Dicke der Fensterschicht (5) zwischen 15 und 25 µm liegt.

3. Lumineszenzdiode nach Anspruch 1 oder 2,
**dadurch gekennzeichnet, daß**
die Konzentration an Aluminium in der Fensterschicht (5) unterhalb von 24 Atom-% liegt.

## Claims

1. Luminescence diode comprising a semiconductor chip (1) based on GaAlAs comprising a diode layer sequence (2) doped amphoterically with the aid of silicon and having a p-doped anode layer (3) and an n-doped cathode layer (4), and comprising a window layer (5) based on GaAlAs, said window layer being adjacent to the n-doped cathode layer (4),
**characterized in that**
the thickness of the window layer (5) lies between 3 µm and 30 µm, and
the window layer (5) is n-doped with the aid of Si or Sn with a net concentration of less than 1 x 10¹⁸ cm⁻³.

2. Luminescence diode according to Claim 1,
**characterized in that**
the thickness of the window layer (5) lies between 15 and 25 µm.

3. Luminescence diode according to Claim 1 or 2,
**characterized in that**
the concentration of aluminium in the window layer (5) lies below 24 atom %.

## Revendications

1. Diode luminescente dotée d'une puce semiconductrice (1) à base de GaAlAs et dotée d'une succession (2) de couches de diodes dopées de manière amphotère au moyen de silicium, la succession présentant une couche d'anode (3) dopée p et une couche de cathode (4) dopée n, avec une couche de fenêtre (5) à base de GaAlAs qui se raccorde à la couche de cathode (4) dopée n,
**caractérisée en ce que**
l'épaisseur de la couche de fenêtre (5) est comprise entre 3 µm et 30 µm et
**en ce que** la couche de fenêtre (5) est dopée n au moyen de Si ou de Sn, à une concentration nette de moins de 1 x 10¹⁸ cm⁻³.

2. Diode luminescente selon la revendication 1, **caractérisée en ce que** l'épaisseur de la couche de fenêtre (5) est comprise entre 15 et 25 µm.

3. Diode luminescente selon les revendications 1 ou 2, **caractérisée en ce que** la concentration en aluminium dans la couche de fenêtre (5) est inférieure à 24 % atomiques.
